# EUROPÄISCHE PATENTSCHRIFT

(11) **EP 2 622 952 B1**
(45) Veröffentlichungstag und Bekanntmachung des Hinweises auf die Patenterteilung: **19.12.2018**
(21) Anmeldenummer: 11766887.1
(22) Anmeldetag: 30.09.2011
(51) Int. Cl.: H05K 7/14

(54) **VORRICHTUNG ZUR AUFNAHME VON TRAGSCHIENEN-MODULGEHÄUSEN**
DEVICE FOR RECEIVING MOUNTING RAIL MODULE HOUSINGS
DISPOSITIF POUR RECEVOIR DES BOÎTIERS MODULAIRES À RAIL PORTEUR

(30) Priorität: 30.09.2010 DE 102010046990
(43) Veröffentlichungstag der Anmeldung: 07.08.2013
(73) Patentinhaber: Phoenix Contact GmbH & Co. KG, 32825 Blomberg (DE)
(72) Erfinder: TRINH, Dat-Minh, 32683 Barntrup (DE); KÄUPER, Heinrich, 33102 Paderborn (DE)
(74) Vertreter: Blumbach · Zinngrebe Patent- und Rechtsanwälte
(86) Internationale Anmeldenummer: PCT/EP2011/004883
(87) Internationale Veröffentlichungsnummer: WO 2012/041509

(56) Entgegenhaltungen:
- EP-A1- 0 407 241
- EP-A2- 0 599 362
- DE-A1- 4 421 267
- DE-A1-102005 032 730

## Beschreibung

Die Erfindung betrifft eine Vorrichtung zur Aufnahme von Tragschienen-Modulgehäusen, welche elektrisch zu kontaktierende Bauteile enthalten.

In der Automatisierungstechnik werden modular aufgebaute elektrische oder optoelektronische Geräte eingesetzt, die zum Beispiel in Schaltschränken montiert werden können. Ein derartiges modulares Gerät ist aus mehreren elektrischen oder optoelektronischen Bauteilen aufgebaut, die in Modulgehäusen untergebracht sind. Um eine kompakte Bauweise und eine übersichtliche Verdrahtung zu erhalten, werden die Modulgehäuse üblicher Weise nebeneinander auf einer Hutschiene aufgerastet und verkabelt.

Mit der Miniaturisierung der elektronischen Schaltungen wurden auch die Modulgehäuse kleiner. Gleichzeitig nahm aber die Anzahl an elektrischen Kontaktstellen zu. Um dieser Entwicklung gerecht zu werden, gibt es Bestrebungen, geeignete Träger für Modulgehäuse bereitzustellen.

Ein derartiger Träger ist beispielsweise aus der EP 1 520 330 B1 bekannt. Der Träger weist zwei im Winkel zueinander angeordnete Schenkel auf. An dem ersten Schenkel ist eine Tragschiene vorgesehen, auf der Modulgehäuse befestigt werden können. Weiterhin sind an dem ersten Schenkel eine Gruppe von Steckverbindern angeordnet, die sich beim Aufrasten eines Modulgehäuses auf die Tragschiene mit komplementären Kontakten des Modulgehäuses paaren. An der Unterseite des ersten Schenkels ist eine Hutschienenhalterung vorgesehen, um den Träger an einer externen Hutschiene befestigen zu können. An der Stirnseite des zweiten Schenkels ist eine Platine verschraubt oder verlötet, die eine Steckverbinderleiste trägt. Beim Aufrasten eines Modulgehäuses paaren sich die Stecker der Platine mit entsprechenden komplementären Kontakten des Modulgehäuses. Die Steckverbinder des ersten und zweiten Schenkels sind derart angeordnet, dass ein Kontaktieren der Steckverbinder die Schwenkbewegungen des Modulgehäuses nicht behindert.

Aufgrund der speziellen Trägerform können nur Modulgehäuse der gleichen Bauform, der gleichen Baubreite und vorbestimmter Anzahl, zum Beispiel 8 oder 16 Modulgehäuse, verwendet werden. Zudem müssen die Kontaktstellen an den Modulgehäusen immer an den gleichen Bereichen angeordnet sein, um mit den Steckverbindern des ersten und zweiten Schenkels gepaart werden zu können.

Aus der DE 44 21 267 A1 ist ein mehrteiliges Interface-Modul bekannt, welches aus einem Gehäuseteil mit einer Hutschiene zur Halterung eines Schaltgerätes und aus einem vom Gehäuseteil getrennten Einschubteil aufgebaut ist, welches die Leiterplatte hält. Der Einschubteil wird auf das Gehäuseteil aufgerastet oder aufgeklemmt.

Aus der EP 0 407 241 A1 ist eine lösbare Platine zur Halterung elektrischer Geräte für eine Leistungsverteilungsvorrichtung bekannt. Auf der Rückseite weist die Platine eine Hutschiene auf, auf die ein elektrisches Gerät aufgerastet werden kann.

Aus der DE 10 2005 032 730 A1 ist ein Träger bekannt, auf den eine einzige Baugruppe eines Automatisierungsgeräts aufschwenkbar ist.

Der vorliegenden Erfindung liegt die Aufgabe zugrunde, eine Vorrichtung zur Aufnahme von Tragschienen-Modulgehäusen bereit zu stellen, welche robust und verschleißarm ist und eine kompakte Bauweise aufweist. Zudem kann sie unterschiedlich dimensionierte Modulgehäuse aufnehmen. Insbesondere können die Modulgehäuse in ihrer Breite und Länge und beliebiger Anzahl variieren. Weiterhin erleichtert die Vorrichtung den Ein- und Ausbau von Leiterplatten und Tragschienen-Modulgehäusen.

Ein Kerngedanke der Erfindung ist in einem einteiligen Träger zu sehen, der verhindern kann, dass eine Leiterplatte und deren Kontakte auch bei einem häufigen Ein- und Ausbau von Tragschienen-Modulgehäusen beschädigt werden. Dies wird insbesondere dadurch erreicht, dass das Modulgehäuse durch Verschwenken in Richtung zur Leiterplatte von einer integralen Tragschiene des Trägers gelöst werden kann. Diese spezielle Verschwenkung wird dadurch ermöglicht, dass die integrale Tragschiene sowie der Haltebereich der Leiterplatte derart räumlich getrennt sind, dass auch im montierten Zustand die Modulgehäuse und die Leiterplatte mechanisch entkoppelt sind. Auch die integrale Tragschiene ist somit von der Leiterplatte entkoppelt.

Das oben genannte technische Problem wird durch die Merkmale des Anspruchs 1 gelöst.

Demnach ist eine Vorrichtung zur Aufnahme von Tragschienen-Modulgehäusen vorgesehen, welche elektrisch zu kontaktierende Bauteile enthalten. Die Vorrichtung umfasst einen einteiligen Träger, welcher einen ersten Haltebereich zum losen Halten einer Leiterplatte und einen zweiten, eine integrierte Tragschiene aufweisenden Haltebereich zum Halten wenigstens eines Tragschienenmodulgehäuses aufweist. Der erste und zweite Haltebereich sind derart im Abstand zueinander angeordnet, dass das wenigstens eine Tragschienen-Modulgehäuse durch Schwenken in Richtung zur Leiterplatte von der integralen Tragschiene gelöst werden kann.

Diese Maßnahme ermöglicht ferner, dass im montierten Zustand der Vorrichtung der die Leiterplatte haltende erste Haltebereich zur Wartungsperson hin zugänglich ist. Damit ist eine kundenfreundliche Wartung der Vorrichtung gegeben. Denn bei Ausfall einer Leiterplatte kann diese schnell und einfach aus dem ersten Haltebereich herausgenommen werden. Auch ist es möglich, eine defekte Leiterplatte auszutauschen, ohne aufgesteckte Modulgehäuse entfernen zu müssen.

Der Ausdruck "loses Halten einer Leiterplatte" bedeutet, dass die Leiterplatte nicht mit separaten Befestigungsmitteln, wie zum Beispiel Schrauben, Nieten oder Kleber an dem ersten Haltebereich befestigt ist. Die Leiterplatte wird allein durch die bestimmte Form des ersten Haltebereichs gehalten.

Dank dieser Maßnahme kann eine Leiterplatte schnell und ohne zusätzliche Hilfsmittel ausgetauscht werden kann.

Die definierte, platzsparende Schwenkrichtung des Modulgehäuses wird zweckmäßigerweise dadurch erreicht, dass das Tragschienen-Modulgehäuse manuell mit auf der Leiterplatte angeordneten Anschlusskontakten verkabelt wird.

Auf diese Wiese können die Modulgehäuse mittels vorkonfektionierter Systemkabel mit mehrpoligen Steckverbindern schnell und fehlerfrei an eine Steuerung angeschlossen werden.

Die Leiterplatte ist vorzugsweise eine Rangierplatte, auf der wenigstens eine Steckverbinderleiste zum Anschließen mehrerer Modulgehäuse angeordnet ist. Darüber hinaus können auf der Leiterplatte weitere Elektronikschaltungen und/oder optische oder optoelektronische Bauteile angeordnet sein.

Mittels der Rangierplatte können die Tragschienen-Modulgehäuse über vorkonfektionierte Systemkabel und Systemstecker an eine übergeordnete Steuerung angeschlossen werden.

Eine flexible Gestaltung der Vorrichtung wird dadurch erreicht, dass der einteilige Träger ein Strangprofil mit anpassbarer Länge ist.

Um zu gewährleisten, dass die Vorrichtung an einer Tragschiene befestigt werden kann, kann an jeder Breitseite des Trägers ein Seitenteil lösbar befestigt sein. Jedes Seitenteil weist eine Halterung auf, mittels derer die Vorrichtung an einer Tragschienen befestigbar ist. Die Vorrichtung kann somit an jeder beliebigen Tragschiene befestigt werden, indem lediglich die Seitenteile mit den komplementären Halterungen ausgewählt werden müssen. Der einstückige Träger muss hierzu nicht ausgetauscht werden.

Um den Seitenbereich des Trägers schützen zu können, können die Seitenteile sich über die gesamte Breite des Trägers erstrecken. Die Seitenteile verhindern zudem, dass die Leiterplatte seitlich aus dem ersten Haltebereich herausrutschen kann. Die Seitenteile und der erste Haltebereich halten in diesem Fall die Leiterplatte an allen vier Seiten.

Vorteilhafterweis weist der Träger integrale Befestigungskonturen zum lösbaren Befestigen der Seitenteile auf.

Der erste Haltebereich ist derart ausgebildet, dass er mehrere Leiterplatten, auch unterschiedlicher Dimensionierung, lose halten kann.

Um einen elektrischen Kurzschluss zwischen der Leiterplatte und dem einteiligen Träger zu verhindern, kann der erste Haltebereich zum losen Halten einer Isolierplatte ausgebildet sein.

Vorteilhafterweise weist der erste Haltebereich zueinander fluchtende Aufnahmebereiche zur losen Aufnahme gegenüberliegender Längsseiten der Leiterplatte und/oder der Isolierplatte auf.

Vorteilhafterweise umfassen die Aufnahmebereiche Nuten.

Um die Modulgehäuse sowie den Kabelverschlag, welcher die Leiterplatte mit den Modulgehäusen verbindet, zu verdecken, ist eine von der Vorrichtung lösbare Trennwand vorgesehen, die wenigstens einen Abschnitt des ersten Haltebereichs vom zweiten Haltebereich trennt.

Vorteilhafterweise sind die Seitenteile zur Führung und Halterung der lösbaren Trennwand ausgebildet.

Gemäß einer vorteilhaften Weiterbildung weist die integrale Tragschiene die Form einer Hutschiene auf. Auf diese Weise können herkömmliche Hutschienen-Modulgehäuse von der Vorrichtung aufgenommen werden.

Um die Tragschienen-Modulgehäuse miteinander, mit einer externen Energieversorgungsquelle und/oder anderen elekronischen Geräten verbinden zu können, kann in die integrale Tragschiene ein T-Bus-Verbinder eingesetzt werden.

Die Aufnahmevorrichtung eignet sich somit insbesondere zur Aufnahme von unterschiedlichen Tragschienen-Modulgehäusen, und zwar in beliebiger Stückzahl.

Die Erfindung wird nachstehend anhand eines Ausführungsbeispiels in Verbindung mit den beiliegenden Zeichnungen näher erläutert. Es zeigen:
- Fig. 1: ein erfindungsgemäßes Strangprofil, in welchem zwei Leiterplatten unterschiedlicher Größe sowie eine Isolierplatte lose gehalten werden,
- Fig. 2: das in Fig. 1 gezeigte Strangprofil, auf welchem ein Trägerschienen-Modulgehäuse, eine bestückte Leiterplatte sowie eine Isolierplatte angeordnet sind,
- Fig. 3: die perspektivische Ansicht einer beispielhaften Aufnahmevorrichtung mit dem in Fig. 1 gezeigten Strangprofil, welches durch Seitenteile begrenzt ist, und
- Fig. 4: eine perspektivische Ansicht der in Fig. 3 gezeigten Aufnahmevorrichtung, welche um 180° bezüglich einer vertikalen Achse gedreht ist.

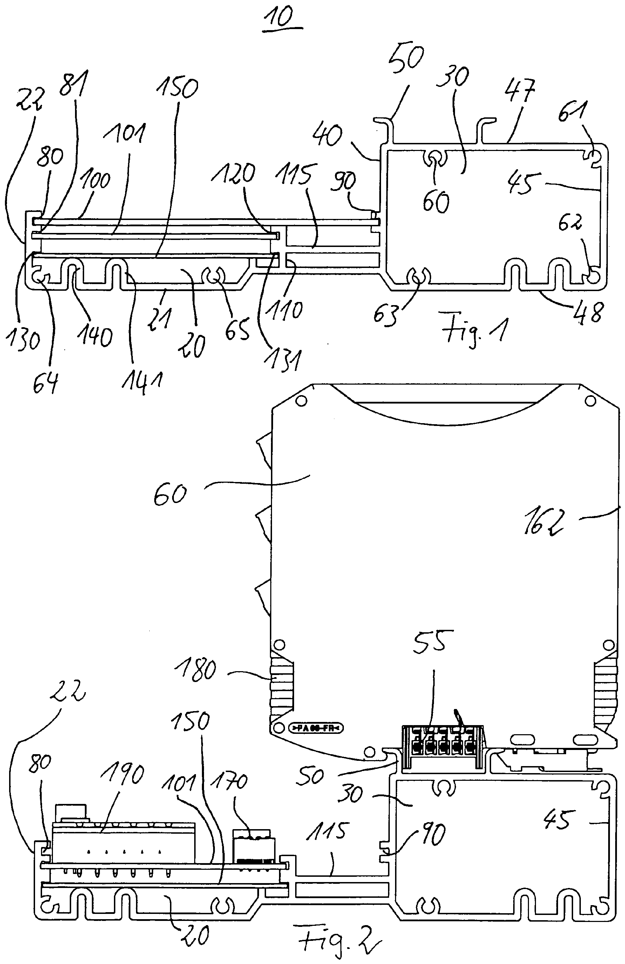

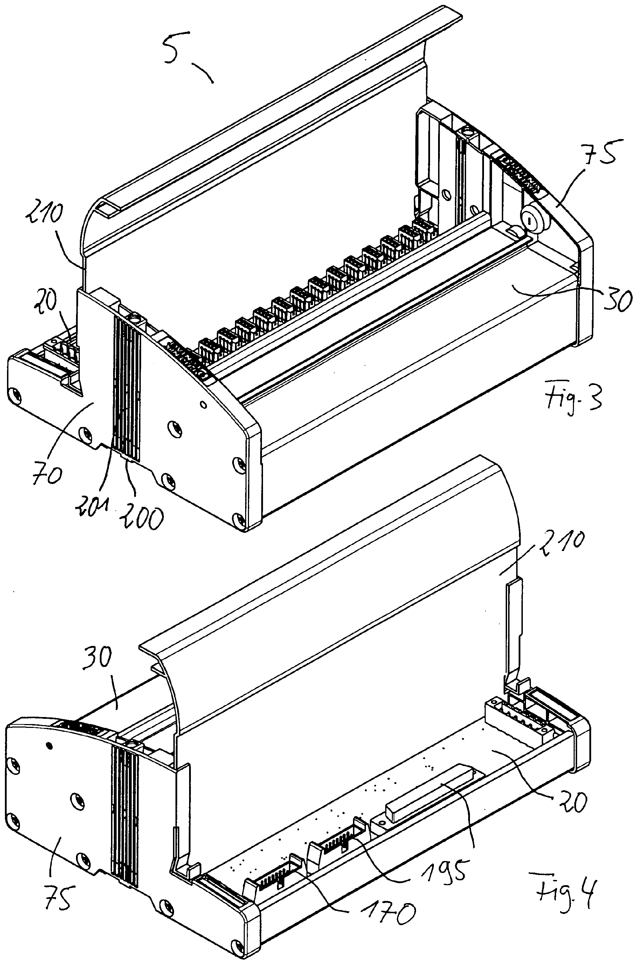

In der Fig. 1 ist ein Strangprofil 10 dargestellt, welches als einteiliger Träger einer in Fig. 3 gezeigten Aufnahmevorrichtung 5 dient. Der einteilige Träger 10 kann aus einem beliebig langen Strangprofil gewonnen werden, welches in seiner Länge frei wählbar ist. Fig. 1 zeigt die Seitenansicht des einteiligen Trägers, der sich senkrecht zur Blattebene erstreckt. Der einteilige Träger 10 weist einen ersten Haltebereich 20 sowie einen zweiten Haltebereich 30 auf. Der Haltebereich 30 kann einen im Wesentlichen rechteckförmigen Querschnitt aufweisen, der durch zwei gegenüberliegende Seiten oder Wände 40 und 45, eine obere Seite 47 und eine untere Seite 48 definiert ist. Auf der Oberseite 47 des Haltebereichs 30 ist eine integrale Tragschiene 50 ausgebildet, die im vorliegenden Beispiel die Form einer Hutschiene annimmt. Angemerkt sei, dass die integrale Tragschiene 50 eine Hutschienenkontur ähnlich der DIN EN60715 aufweisen kann. An dem Haltebereich 30 sind integrale Befestigungsmittel 60, 61, 62 und 63 vorgesehen, die sich über die gesamte Länge des Trägers 10 erstrecken können. Auch die Tragschiene 50 erstreckt sich über die gesamte Länge des Trägers 10. Mittels der Befestigungsmittel 60 bis 63 können Seitenteile 70 und 75 an den Träger befestigt werden, wie dies in Fig. 3 und 4 gezeigt ist. An die Seitenwand 40 des Haltebereichs 30 schließt sich im vorliegenden Beispiel der Haltebereich 20 an. Der Haltebereich 20 enthält eine im Wesentlichen eben verlaufende Bodenfläche 21, die am unteren Abschnitt der Seitenwand 40 des Haltebereichs 30 ansetzt und vorzugsweise parallel zur Bodenseite 48 verläuft. Am äußeren Ende der Bodenfläche 21 ist ein Wandteil 22 angeformt, welches vorzugsweise parallel zur Seitenwand 40 des Haltebereichs 30 verläuft. Im oberen Bereich des Wandteils 22 sind im Abstand zueinander zwei Nuten 80, 81 ausgenommen, die zur Seitenwand 40 hin geöffnet sind. Fluchtend zur Nut 80 sind an der Seitenwand 40 des Halterbereichs 30 zwei Vorsprünge vorgesehen, die eine Nut 90 definieren. Die Nuten 80, 81 und 90 erstrecken sich vorteilhafterweise über die gesamte Länge des Trägers 10. In die Nuten 80 und 90 kann eine Leiterplatte 100 lose eingesetzt werden. Zwischen dem äußeren Wandteil 22 und der dazu parallel verlaufenden Seitenwand 40 kann ein zur Seitenwand 40 parallel verlaufender Steg 110 liegen, der sich senkrecht vom Bodenteil 21 nach oben erstrecken. Der Steg 110 weist eine integrale Nut 120 auf, welche zur Nut 81 in dem Wandteil 22 fluchtend angeordnet ist. Die Nuten 81 und 120 definieren eine weitere Haltung des Haltebereichs 20, welche eine weitere Leiterplatte 101 lose halten kann. Wie die Fig. 1 zeigt, weisen die Leiterplatten 100 und 101 unterschiedliche Dimensionen auf. Im vorliegenden Beispiel ist zu sehen, dass die Seitenwand 40 auch als Trennlinie zwischen dem ersten Haltebereich 20 und zweiten Haltebereich 30 interpretiert werden kann. In der Praxis ist in der Regel nur eine der Leiterplatten 100, 101 in dem Träger 10 eingesetzt. Zwischen dem Steg 110 und der Seitenwand 40 kann eine Versteifungsfläche 115 verlaufen, die für eine gute Stabilität und Vibrationsfestigkeit des Trägers 10 sorgt.

Der Wandteil 22 weist einen Vorsprung 130 auf, der fluchtend zu einem Vorsprung 131 an dem Steg 110 angeordnet ist. Die untere Bodenfläche 21 des Haltebereichs 20 weist Stützprofile 140, 141 und 142 auf, die zusammen mit den Unterkanten der Vorsprünge 130 und 131 einen Aufnahme- oder Haltebereich für eine Isolierplatte 150 bilden. Eine Isolierplatte 150 ist unterhalb der Leiterplatten 100 und 101 angeordnet und verhindert, dass die Leiterplatten mit dem Bodenteil 21 des Haltebereichs 20 in elektrischen Kontakt treten können.

An dieser Stelle sei betont, dass das in Fig. 1 gezeigte Strangprofil nur ein Ausführungsbeispiel darstellt. Wichtig ist lediglich, dass die integrale Tragschiene 50 und die Leiterplatte 100 beziehungsweise die Leiterplatte 101 räumlich getrennt voneinander angeordnet sind, und zwar derart, dass ein auf der Hutschiene 50 aufgesetztes Tragschienen-Modulgehäuse durch Schwenken in Richtung zur Leiterplatte 100 oder 101 von der integralen Tragschienen 50 gelöste werden kann. Zweckmäßiger Weise ist die Leiterplatte 100 oder 101 unterhalb der Hutschiene 50 angeordnet.

Der erste Haltebereich 20 weist beispielsweise im Bereich der Bodenfläche 21 Befestigungsmittel 64 und 65 auf, an die die Seitenteile 70 und 75 lösbar befestigt werden können.

Denkbar ist ferner, dass zum Beispiel die Nuten 80 und 90 in der Höhe versetzt zueinander angeordnet sind, so dass die Leiterplatte 100 unter einem vorbestimmten Winkel zur Bodenfläche 21 gehalten werden kann.

Fig. 2 zeigt den einteiligen Träger 10 nach Fig. 1. In die integrale Tragschiene 50 ist ein T-Bus-Verbinder 55 lösbar eingesetzt. Über den T-Bus-Verbinder 55 können Tragschienen-Modulgehäuse 160 beziehungsweise deren elektronische und/oder optoelektronische Komponenten mit Spannung versorgt werden und/oder miteinander kommunizieren. Beispielsweise können auf diese Weise Fehlermeldungen übertragen werden.

Auf der Hutschiene 50 können mehrere Tragschienen-Modulgehäuse 160 aufgesetzt sein, die sich in der Bauweise und insbesondere in der Baubreite unterscheiden können. Aufgrund der Seitenansicht ist nur ein Tragschienen-Modulgehäuse 160 zu sehen. Zu beachten ist, dass die Rückseite 162 des Tragschienen-Modulgehäuses mit der außen liegenden Wand 45 des Trägers 10 bündig abschließen kann. Auf diese Weise ist es möglich, den bestückten einteiligen Träger 10 platzsparend beispielsweise in einem Schaltschrank zu montieren. Im Haltebereich 20 ist die Leiterplatte 101 eingesetzt, welche von den Nuten 81 und 120 lose gehalten wird. Zwischen der Bodenfläche 21 und der Leiterplatte 101 ist die Isolierplatte 150 angeordnet. Die Leiterplatte 101 ist als Rangierplatte ausgebildet und weist wenigstens eine Steckverbinderleiste 170 auf. Die Steckverbinderleiste 170 kann sich über die gesamte Länge des Trägers 10 erstrecken. Beispielsweise an der Vorderseite des Tragschienen-Modulgehäuses 60 sind Kontakte 180 vorgesehen, die über vorkonfektionierte Kabel mit entsprechenden Anschlusskontakten der Steckverbinderleiste 170 manuell verbunden werden können. Diese Verkabelung ist in Fig. 2 nicht dargestellt. Auf der Leiterplatte 101 können weitere elektronische und/oder optoelektronische Bauteile 190 montiert sein.

Wie Fig. 2 zeigt, kann das Tragschienen-Modulgehäuse 160 zum Lösen von der Tragschiene 50 in Richtung der Leiterplatte 101 geschwenkt werden. Zuvor müssen lediglich die Kabel von den Kontakten 180 und/oder von der Steckverbinderleiste 170 entfernt werden. Dank der besonderen räumlichen Anordnung von Hutschiene 50 und Leiterplatte, das heißt der besonderen räumlichen Trennung zwischen dem ersten Haltebereich 20 und dem zweiten Haltebereich 30, sowie der manuellen Verkabelung des Tragschienen-Modulgehäuses 160 können unterschiedliche Tragschienen-Modulgehäuse mit unterschiedlicher Baubreite und unterschiedlicher Anordnung der Kontakte 180 auf dem einteiligen Träger 10 aufgesetzt werden. Zudem sorgt die Kontur des Haltebereichs 20 dafür, dass die Leiterplatte 101 beziehungsweise 100 mechanisch geschützt gehalten werden kann. Wie Fig. 2 zeigt, verhindert die Isolierplatte 150, dass Kontaktstifte der Leiterplatte 101 in elektrischen Kontakt mit dem Träger 10 treten können.

Fig. 3 zeigt die beispielhafte, modularartig aufgebaute Aufnahmevorrichtung 5, welche den in Fig. 1 gezeigten einteiligen Träger 10 enthält. Weiterhin ist an jeder Breitseite des Trägers 10 das Seitenteil 70 beziehungsweise das Seiten 75 lösbar befestigt. Die Seitenteile 70 und 75 können beispielsweise mittels Schrauben, welche in die Befestigungskonturen 60 bis 65 des Trägers 10 eingeschraubt werden, befestigt werden. Jedes Seitenteil 70 und 75, die vorzugsweise annähernd spiegelverkehrt zueinander ausgebildet sind, weist Befestigungsmittel 200 zur Montage an einer externen Tragschiene auf. Im vorliegenden Beispiel sind die Befestigungsmittel 200 derart ausgebildet, dass die Aufnahmevorrichtung 5 auf einer externen Hutschiene (nicht dargestellt) montiert werden kann. Die Konturen des ersten Haltebereichs 20 und die beiden Seitenteile 70 und 75 sorgen dafür, dass die eingesetzte Leiterplatte 100 oder 101 und die Isolierplatte 150 an allen vier Seiten vollumfänglich gehalten werden, ohne das separate Befestigungsmittel wie Schrauben und dergleichen benötigt werden.

Die externe Hutschiene kann wiederum in einem Schaltschrank angeordnet sein. Die Befestigungsmittel 200 können eine Stellschraube 201 in Verbindung mit einer Grelle umfassen, mittels derer die Aufnahmevorrichtung 5 auf der nicht dargestellten externen Hutschiene befestigt werden kann. Weiterhin weist jedes Seitenteil 70 und 75 Konturen auf, in welche eine Abdeckung 210, nachfolgend auch Trennwand genannt, einführbar ist. Diese Konturen dienen als Führung und Halterung der Trennwand 210. Die Trennwand 210 steht vorzugsweise senkrecht zur Bodenfläche 21 des Haltebereichs 20. Sie sitzt vorzugsweise vor der Steckverbinderleiste 170, so dass sowohl die Verkabelung (nicht dargestellt) als auch die dahinterliegenden Tragschienen-Modulgehäuse 160 für das Personal nicht sichtbar sind.

Zur räumlichen Orientierung sei angemerkt, dass der Haltebereich 30 beispielsweise der Wand eines Schaltschranks zugewandt ist, während der Haltebereich 20 für den Kunden oder das Bedienpersonal zugänglich ist. Mit anderen Worten sieht das Bedienpersonal lediglich die elektronischen Komponenten 190, welche in Fig. 2 und Fig. 4 dargestellt sind. Neben den elektronischen Komponenten 190 können auch weitere Verbinder und/oder Verbinderleisten 195 auf der Platine 101 angeordnet sein.

In Fig. 4 ist die in Fig. 3 gezeigte Aufnahmevorrichtung 5 um 180° gedreht dargestellt. Dies bedeutet, dass nunmehr der Haltebereich 20 des Trägers 10 auf der rechten Seite liegt.

Der modularartige Aufbau der Aufnahmevorrichtung 5 erlaubt dem Bedienpersonal, ohne großen Aufwand und schnell beispielsweise defekte Leiterplatten auszutauschen. Hierzu müssen noch nicht einmal die Modulgehäuse 160 von der Hutschiene 50 entfernt werden. Vielmehr genügt es, die Verkabelung zwischen der Steckverbinderleiste 170 und den Kontakten 180 der Tragschienen-Modulgehäuse 160 zu lösen. Anschließend kann die defekte Leiterplatte aus dem Halterbereich 20 herausgenommen werden. Gegebenenfalls muss noch die Trennwand 210 und eine der Seitenwände 70 oder 75 entfernt werden.

Um Tragschienen-Modulgehäuse 160 entfernen zu können, muss lediglich die Trennwand 210 aus den Seitenteilen 70 und 75 herausgezogen und die Kabelverbindungen zwischen der Steckverbinderleiste 170 und den Kontakten 180 des Modulgehäuses 160 gelöst werden. Durch ein einfaches Verschwenken des entsprechenden Modulgehäuses in Richtung zur Leiterplatte 101 kann dieses gelöst werden. Diese spezielle Verschwenkung wird dadurch ermöglicht, dass die integrale Hutschiene 50 sowie der Haltebereich 20 derart räumlich getrennt sind, dass auch im montierten Zustand die Modulgehäuse 160 und die Leiterplatte 100 oder 101 mechanisch entkoppelt sind.

Um zum Beispiel eine hutschienenfreie Direktmontage zu ermöglichen, kann das Strangprofil auf der Unterseite über Nuten verfügen, um zum Beispiel mit Montageplatten verschraubt werden zu können.

## Patentansprüche

1. Vorrichtung (5) zur Aufnahme von Tragschienen-Modulgehäusen (160) umfassend
wenigstens ein Tragschienen-Modulgehäuse (160), welches elektrisch zu kontaktierende Bauteile enthält, wenigstens eine Leiterplatte (100, 101) und einen einteiligen Träger (10), welcher einen ersten Haltebereich (20), der zum losen Halten der wenigstens einen Leiterplatte (100,101) ausgebildet ist, und der eine vorbestimmte Form aufweist, wobei die wenigstens eine Leiterplatte (100,101) allein durch die bestimmte Form des ersten Haltebereichs gehalten wird, und einen zweiten, eine integrale Tragschiene (50) aufweisenden Haltebereich (30) zum Halten des wenigstens einen Tragschienen-Modulgehäuse (160) aufweist, wobei der erste Haltebereich (20) unterhalb und seitlich der integralen Tragschiene (50) angeordnet ist, so dass das wenigstens eine Tragschienen-Modulgehäuse (160) durch Schwenken in Richtung zur Leiterplatte (100, 101) von der integralen Tragschiene (50) gelöst werden kann, wobei
der einteilige Träger (10) ein Strangprofil vorbestimmbarer Länge ist.

2. Vorrichtung nach Anspruch 1,
**dadurch gekennzeichnet, dass**
die Leiterplatte (100, 101) Anschlusskontakte (170) aufweist, mit denen das wenigstens eine Tragschienen-Modulgehäuse (160) manuell verkabelt ist.

3. Vorrichtung nach einem der vorstehenden Ansprüche,
**dadurch gekennzeichnet, dass**
an jeder Breitseite des Trägers ein Seitenteil (70, 75) lösbar befestigbar ist, wobei jedes Seitenteil (70, 75) eine Halterung (200, 201) aufweist, mittels derer die Vorrichtung (5) an einer Tragschiene befestigbar ist.

4. Vorrichtung nach Anspruch 3,
**dadurch gekennzeichnet, dass**
die Seitenteile (70, 75) sich über die gesamte Breite des Trägers (10) erstrecken.

5. Vorrichtung nach Anspruch 3 oder 4,
**dadurch gekennzeichnet, dass** der einteilige Träger (10) integrale Befestigungskonturen (60-65) zum lösbaren Befestigen der Seitenteile (70,75) aufweist.

6. Vorrichtung nach einem der Ansprüche 3 bis 5,
**dadurch gekennzeichnet**, das
die Seitenteile (70, 75) zur Führung und Halterung einer lösbaren Trennwand (210) ausgebildet sind, welche wenigstens einen Abschnitt des ersten Haltebereichs (20) vom zweiten Haltebereich (30) trennt.

7. Vorrichtung nach einem der vorstehenden Ansprüche,
**dadurch gekennzeichnet, dass**
der erste Haltebereich (20) zum losen Halten von Leiterplatten (100, 101) unterschiedlicher Dimensionierung ausgebildet ist.

8. Vorrichtung nach einem der vorstehenden Ansprüche,
**dadurch gekennzeichnet, dass**
der erste Haltebereich (20) zum losen Halten einer Isolierplatte (150) ausgebildet ist.

9. Vorrichtung nach einem der vorstehenden Ansprüche,
**dadurch gekennzeichnet, dass**
der erste Haltebereich (20) zueinander fluchtende Aufnahmebereiche (80, 90; 81, 120) zur losen Aufnahme gegenüberliegender Längsseiten einer Leiterplatte (100, 101) aufweist.

10. Vorrichtung nach Anspruch 9,
**dadurch gekennzeichnet, dass**
die Aufnahmebereiche Nuten umfassen.

11. Vorrichtung nach einem der vorstehenden Ansprüche,
**dadurch gekennzeichnet, dass**
die integrale Tragschiene (50) die Form einer Hutschiene aufweist.

## Claims

1. A device (5) for accommodating mounting rail module housings (160), comprising
at least one mounting rail module housing (160) which contains components that are to be contacted electrically;
at least one circuit board (100, 101), and
a one-piece support (10) which comprises a first supporting area (20) which is configured for loosely holding the at least one circuit board (100, 101) and which has a defined shape, the at least one circuit board (100, 101) being held alone by virtue of the defined shape of the first supporting area (20), and a second supporting area (30) having an integral mounting rail (50) for holding at least one mounting rail module housing (160), wherein the first supporting area (20) is arranged at a lower level and laterally relative to the integral mounting rail (50), so that the at least one mounting rail module housing (160) can be released from the integral mounting rail (50) by pivoting it in the direction of the circuit board (100, 101);
wherein the one-piece support (10) is an extruded profile of a predeterminable length.

2. The device according to claim 1,
**characterised in that** the circuit board (100, 101) has terminals (170) to which the at least one mounting rail module housing (160) is wired manually.

3. The device according to any one of the preceding claims,
**characterised in that** a side part (70, 75) can be detachably attached to each broadside of the support, wherein each side part (70, 75) has a holder (200, 201) by means of which the device (5) can be mounted on a mounting rail.

4. The device according to claim 3,
**characterised in that** the side parts (70, 75) extend over the entire width of the support (10).

5. The device according to claim 3 or 4,
**characterised in that** the one-piece support (10) has integral fastening contours (60 - 65) for detachable attachment of the side parts (70, 75).

6. The device according to any one of claims 3 to 5,
**characterised in that** the side parts (70, 75) are configured for guiding and holding a detachable partition (210) which is separating at least a section of the first supporting area (20) from the second supporting area (30).

7. The device according to any one of the preceding claims,
**characterised in that** the first supporting area (20) is configured for loosely holding circuit boards (100, 101) of different dimensions.

8. The device according to any one of the preceding claims,
**characterised in that** the first supporting area (20) is configured for loosely holding an insulating board (150) .

9. The device according to any one of the preceding claims,
**characterised in that** the first supporting area (20) has mutually aligned accommodating areas (80, 90; 81, 120) for loosely accommodating opposite longitudinal sides of a circuit board (100, 101).

10. The device according to claim 9,
**characterised in that** the accommodating areas comprise grooves.

11. The device according to any one of the preceding claims,
**characterised in that** the integral mounting rail (50) is in the form of a hat rail.

## Revendications

1. Dispositif (5) pour recevoir des boîtiers modulaires à rail porteur (160), comportant :
au moins un boîtier modulaire à rail porteur (160), lequel contient des composants à mettre en contact électriquement,
au moins une carte de circuits imprimés (100, 101) et un support (10) d'une seule pièce, lequel présente une première zone de retenue (20) qui est conçue pour retenir de manière lâche l'au moins une carte de circuits imprimés (100, 101), et qui présente une forme prédéfinie, l'au moins une carte de circuits imprimés (100, 101) étant retenue uniquement par la forme définie de la première zone de retenue, et une deuxième zone de retenue (30) présentant un rail porteur intégral (50) et destinée à retenir l'au moins un boîtier modulaire à rail porteur (160), la première zone de retenue (20) étant située au-dessous et à côté du rail porteur intégral (50), de sorte que l'au moins un boîtier modulaire à rail porteur (160) peut être détaché du rail porteur intégral (50) à la suite d'un pivotement en direction de la carte de circuits imprimés (100, 101), le support (10) d'une seule pièce étant un profilé extrudé d'une longueur pouvant être prédéfinie.

2. Dispositif selon la revendication 1, **caractérisé en ce que** la carte de circuits imprimés (100, 101) présente des contacts de connexion (170), au moyen desquels l'au moins un boîtier modulaire à rail porteur (160) est câblé manuellement.

3. Dispositif selon l'une quelconque des revendications précédentes, **caractérisé en ce qu'**une partie latérale (70, 75) peut être fixée de manière détachable à chaque côté long, chaque partie latérale (70, 75) comprenant un élément de retenue (200, 201) au moyen duquel le dispositif (5) peut être fixé à un rail porteur.

4. Dispositif selon la revendication 3, **caractérisé en ce que** les parties latérales (70, 75) s'étendent sur toute la largeur du support (10).

5. Dispositif selon la revendication 3 ou 4, **caractérisé en ce que** le support (10) d'une seule pièce présente des contours de fixation (60-65) intégraux pour la fixation détachable des parties latérales (70, 75).

6. Dispositif selon l'une quelconque des revendications 3 à 5, **caractérisé en ce que** les parties latérales (70, 75) sont conçues pour guider et retenir une cloison (210) détachable, laquelle sépare au moins une section de la première zone de retenue (20) de la deuxième zone de retenue (30).

7. Dispositif selon l'une quelconque des revendications précédentes, **caractérisé en ce que** la première zone de retenue (20) est conçue pour retenir de manière lâche des cartes de circuits imprimés (100, 101) d'un dimensionnement différent.

8. Dispositif selon l'une quelconque des revendications précédentes, **caractérisé en ce que** la première zone de retenue (20) est conçue pour retenir de manière lâche une plaque isolante (150).

9. Dispositif selon l'une quelconque des revendications précédentes, **caractérisé en ce que** la première zone de retenue (20) présente des zones de logement (80, 90 ; 81, 120) au même niveau les unes que les autres pour le logement lâche des côtés longs opposés d'une carte de circuits imprimés (100, 101).

10. Dispositif selon la revendication 9, **caractérisé en ce que** les zones de logement comportent des rainures.

11. Dispositif selon l'une quelconque des revendications précédentes, **caractérisé en ce que** le rail porteur intégral (50) présente la forme d'un profilé chapeau.
